Europäisches Patentamt

**European Patent Office**

Office européen des brevets

(19)

(11) Numéro de publication: **0 028 960
B1**

(12) # FASCICULE DE BREVET EUROPEEN

(45) Date de publication du fascicule du brevet:
20.07.83

(51) Int. Cl.³: **H 01 L 27/14**

(21) Numéro de dépôt: **80401523.8**

(22) Date de dépôt: **28.10.80**

(54) **Matrice de détection d'un rayonnement électromagnétique et intensificateur d'images radiologiques comportant une telle matrice.**

(30) Priorité: **09.11.79 FR 7927708**

(43) Date de publication de la demande:
**20.05.81 Bulletin 81/20**

(45) Mention de la délivrance du brevet:
**20.07.83 Bulletin 83/29**

(84) Etats contractants désignés:
**DE GB NL**

(56) Documents cités:
**US-A-3 435 138**
**US-A-3 488 508**

(73) Titulaire: **THOMSON-CSF, 173, Boulevard Haussmann,
F-75379 Paris Cedex 08 (FR)**

(72) Inventeur: **Fraleux, Jean, "THOMSON-CSF"
SCPI 173, Bld. Haussmann, F-75360 Paris Cedex 08 (FR)**
Inventeur: **Ploix, Jean-Luc, "THOMSON-CSF"
SCPI 173, Bld. Haussmann, F-75360 Paris Cedex 08 (FR)**

(74) Mandataire: **Benichou, Robert et al, THOMSON-CSF
SCPI 173 bld Haussmann, F-75379 Paris Cedex 08 (FR)**

## Matrice de détection d'un rayonnement électromagnétique et intensificateur d'images radiologiques comportant une telle matrice

La présente invention concerne une matrice de détection d'un rayonnement électromagnétique. Elle concerne également les intensificateurs radiologiques comportant une telle matrice.

On connaît, dans l'art antérieur, des matrices de détection d'un rayonnement électromagnétique qui sont constituées de transistors à effet de champ à jonction ou JFET. Ces transistors sont périodiquement mis à l'état bloqué par une impulsion appliquée sur leur grille qui est ensuite laissée flottante. Le rayonnement reçu par chaque transistor réduit l'épaisseur de la couche désertée sous sa grille, provoque l'ouverture de son canal, et donc le déblocage du transistor. Lors de l'application d'une impulsion de lecture au drain ou à la source de chaque transistor, il circule entre le drain et la source un courant dont l'importance est liée au rayonnement reçu par chaque transistor.

Ces matrices sont généralement réalisées sur des matériaux semi-conducteurs monocristallins, tels que du silicium par exemple.

Cependant, lorsqu'il s'agit de réaliser de grandes surfaces de détection, ayant 20 à 30 cm de côté, comme il n'est pas techniquement possible d'obtenir d'aussi grandes surfaces de semi-conducteurs monocristallins, on utilise des matrices de détection d'un rayonnement électromagnétique, telles que celle décrite par le brevet US-A No 3435138, où les éléments photosensibles, constitués de transistors MOS, sont réalisés en technologie film mince sur un même substrat diélectrique.

Les problèmes qui se posent avec les matrices connues de l'art antérieur, et que notre invention permet de résoudre, sont les suivants:

— la détection d'un rayonnement de faible niveau, de l'ordre de $10^{-7}$ lx;

— l'obtention de fréquences de fonctionnement compatibles avec les standards TV;

— la diminution de la valeur des signaux électriques transportés de chaque détecteur vers la sortie de la matrice.

La matrice de détection d'un rayonnement électromagnétique selon l'invention comporte des éléments photosensibles réalisés en technologie film mince sur un même substrat diélectrique et disposés à chaque point d'intersection de lignes et de colonnes. Des moyens d'adressage des éléments photosensibles sont constitués par un transistor MOS, réalisé en technologie film mince et associé à chaque élément photosensible. Selon l'invention, chaque transistor d'adressage reçoit périodiquement sur sa grille une impulsion de déblocage appliquée simultanément à tous les transistors d'adressage d'une même ligne d'éléments photosensibles. Des moyens d'amplification du signal électrique fourni par chaque élément photosensible sont associés à chacun de ces éléments photosensibles et réalisés en technologie film mince. Enfin, des moyens transfèrent vers un amplificateur vidéo les signaux électriques fournis par chaque ligne d'éléments adressée, ces moyens étant constitués par un dispositif à entrées parallèles et à sortie série auquel sont reliés tous les transistors d'adressage.

La matrice selon l'invention présente de nombreux avantages parmi lesquels on peut citer:

— la possibilité d'obtenir des matrices de détection de grandes surfaces, de 20 à 30 cm de côté par l'utilisation d'éléments photosensibles, des moyens d'adressage et des moyens d'amplification en technologie film mince, réalisés par évaporation sur un substrat diélectrique qui est généralement du verre;

— la possibilité, dans des modes de réalisation préférés, de résoudre les problèmes posés par les fluctuations de la tension de seuil d'un transistor MOS en film mince à l'autre;

— sa grande simplicité de réalisation et son rendement élevé, particulièrement dans les modes de réalisation où un seul signal périodique est nécessaire à son fonctionnement;

— la lecture non destructive et la possibilité de régler aisément le temps d'intégration de l'image.

D'autres objets, caractéristiques et résultats de l'invention ressortiront de la description suivante, donnée à titre d'exemple non limitatif et illustrée par les figures annexées qui représentent:

— la fig. 1, un schéma de principe d'une matrice selon l'invention;

— les fig. 2 et 3, deux modes de réalisation d'une matrice selon l'invention.

Sur les différentes figures, les mêmes repères désignent les mêmes éléments mais, pour des raisons de clarté, les cotes et proportions des différents éléments n'ont pas été respectées.

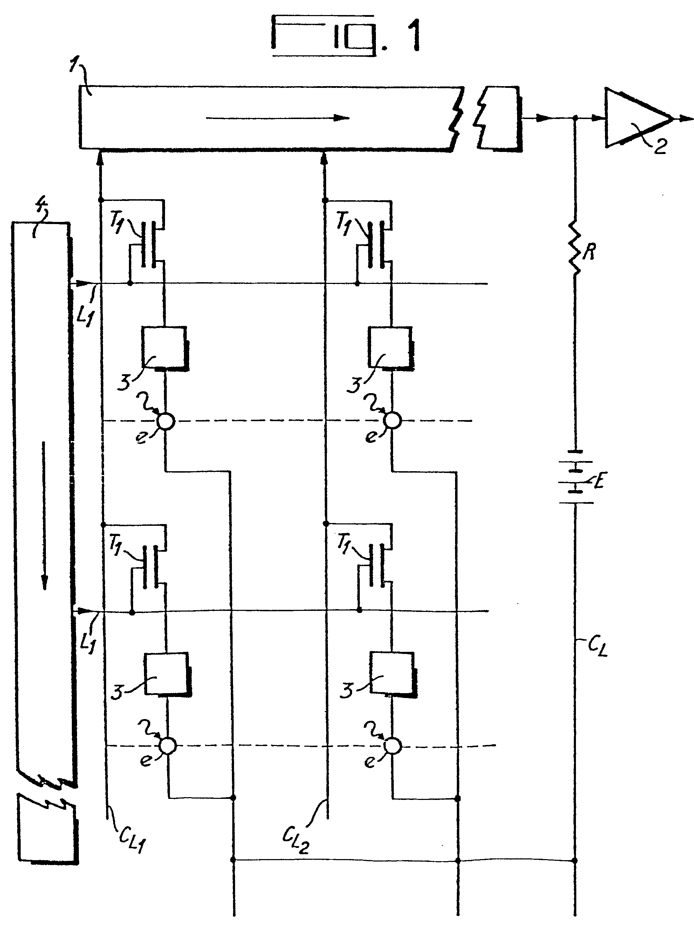

La fig. 1 représente un schéma de principe d'une matrice selon l'invention.

La matrice selon l'invention comporte un élément photosensible e à chaque point de croisement de lignes et de colonnes perpendiculaires entre elles. Ces éléments photosensibles sont réalisés en technologie film mince par évaporation sur un même substrat diélectrique qui est généralement du verre. Ces éléments photosensibles e sont soit des photodiodes, soit des photoconductances.

Le matériau qui les constitue dépend du rayonnement à détecter. Dans le cas d'un rayonnement visible, les détecteurs peuvent être en sulfure de cadmium, CdS, dans le cas d'un rayonnement X, les détecteurs peuvent être en tellurure de cadmium, CdTe.

Des moyens assurent l'adressage d'une ligne d'éléments photosensibles à la fois. Ces moyens sont constitués par des transistors MOS en séléniure de cadmium CdSe par exemple, réalisés en technologie film mince, T1, qui sont associés à chaque élément photosensible e. Chaque transistor d'adressage T1 reçoit périodiquement sur sa grille une impulsion de déblocage L1 qui est appliquée simultanément à tous les transistors d'adressage d'une même ligne. L'impulsion de déblocage L1 est obtenue, de façon connue, par un registre 4 qui véhicule une impulsion de déblocage ou par un multiplexeur.

Les transistors d'adressage T1 relatifs à une même colonne d'éléments photosensibles e sont reliés par une même colonne CL₁, CL₂, ... CLₙ à des moyens de transfert 1 connectés à un amplificateur vidéo 2. Ces moyens de transfert sont constitués par un dispositif à N entrées parallèles et à sortie série.

Chaque ligne d'éléments photosensibles adressée, c'est-à-dire chaque ligne d'éléments photosensibles dont les transistors d'adressage T1 sont rendus conducteurs, envoie donc des signaux électriques représentatifs du rayonnement reçu par chaque élément photosensible, en parallèle, vers les moyens de transfert 1 reliés à l'amplificateur vidéo 2.

Les moyens de transfert peuvent être réalisés en technologie film mince. Ils peuvent aussi être constitués de composants en silicium tels qu'un registre à décalages à transfert de charge du type BBD ou CCD ou un multiplexeur. Etant donné la fréquence de coupure un peu faible des transistors en film mince d'adressage T1, les moyens de transfert sont de préférence constitués de deux dispositifs susceptibles de stocker et de restituer les signaux électriques. Lorsque l'un de ces dispositifs reçoit les signaux électriques en provenance d'une ligne d'éléments photosensibles, l'autre dispositif transfère les signaux en provenance de la ligne précédente vers l'amplificateur vidéo. A la ligne suivante, le rôle de chaque dispositif est inversé. Il est même possible d'utiliser plusieurs couples de dispositifs de réception et de transfert des signaux si la fréquence de coupure des transistors d'adressage T1 l'exige. Des moyens 3 d'amplification du signal électrique fourni par chaque élément photosensible e sont associés à chaque élément photosensible et réalisés en technologie film mince. Ces moyens 3 sont représentés symboliquement par un carré sur la figure. L'amplification au niveau de chaque élément photosensible s'est révélée nécessaire en raison de la valeur relativement importante de la capacité des lignes verticales appelées colonnes qui amènent les signaux électriques aux moyens de transfert 1 par rapport aux lignes horizontales qui véhiculent les impulsions ou signaux de commande, tels que l'impulsion de déblocage L1, qui sont nécessaires au fonctionnement de la matrice.

Cette capacité entre lignes et colonnes provoque une diminution de la valeur des signaux électriques transportés qui deviennent ainsi très sensibles aux parasites. L'amplification au niveau de chaque élément photosensible permet de résoudre ce problème.

Sur la fig. 1, on n'a représenté que les moyens d'adressage et d'amplification associés à quatre éléments photosensibles.

On donnera par la suite le nom de modules élémentaires à chaque élément photosensible auquel sont associés des moyens d'adressage, d'amplification et divers éléments tels qu'une résistance ou une capacité.

Les modules élémentaires sont connectés entre l'une des colonnes CL₁, CL₂ ... CLₙ et une colonne commune CL reliée au point commun aux moyens de transfert 1 et à l'amplificateur vidéo 2: cette colonne CL comporte une source de tension continue E en série avec une résistance R.

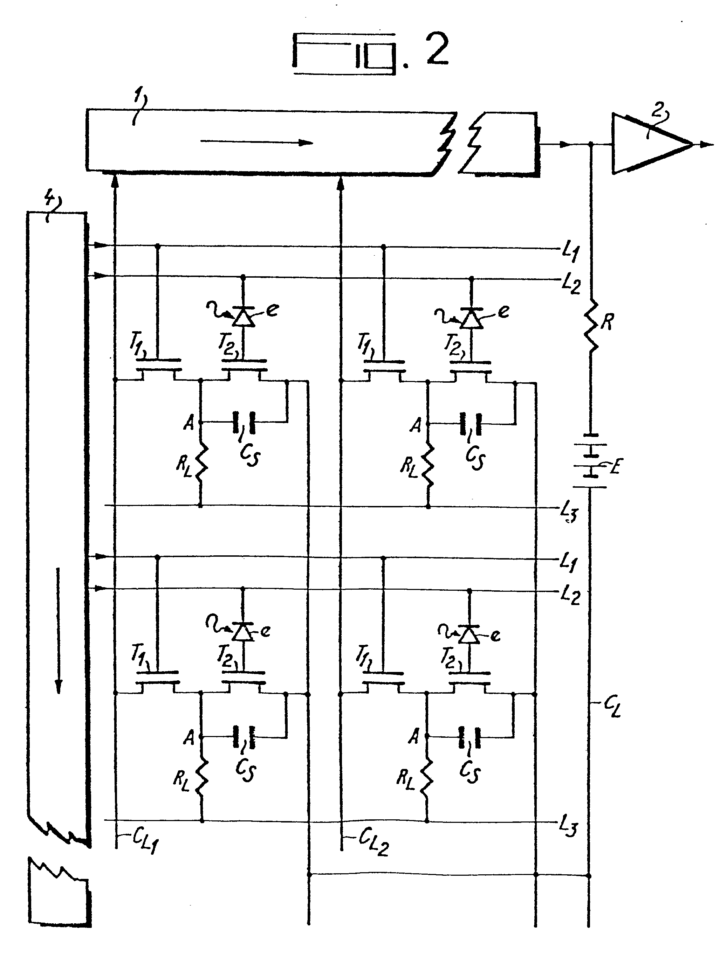

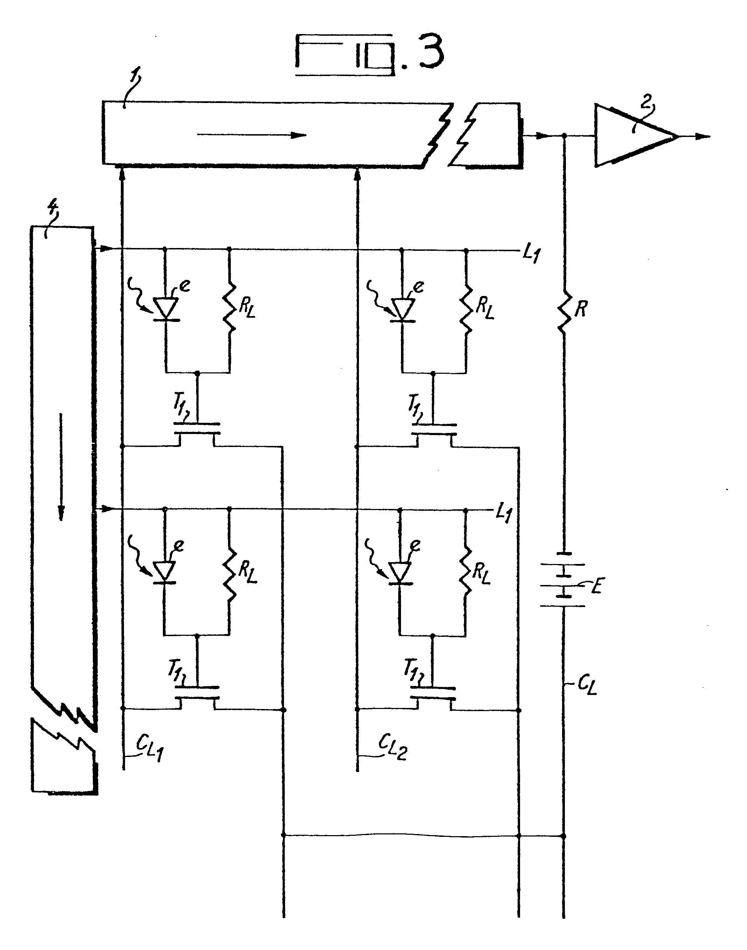

Les fig. 2 et 3 représentent deux modes de réalisation de la matrice selon l'invention.

Dans le mode de réalisation représenté sur la fig. 2, les éléments photosensibles e sont constitués par des photodiodes. Les moyens d'amplification sont constitués par un transistor MOS en technologie film mince T2 qui est relié entre chaque transistor d'adressage T1 et la borne positive de la source E. On appelle A la borne commune aux transistors T1 et T2. La grille de chaque transistor d'amplification T2 est reliée à une photodiode e qui reçoit une tension de commande L2 véhiculée par une ligne horizontale aux photodiodes d'une même ligne. La photodiode e reçoit le rayonnement à détecter qui est symbolisé par une flèche ondulée sur la figure.

Dans l'exemple représenté sur la fig. 2, le transistor d'amplification devient conducteur lorsqu'une impulsion positive est appliquée sur sa grille. Enfin, l'anode de la diode e est reliée à la grille de T2. Il serait bien sûr possible d'obtenir le même fonctionnement en utilisant un transistor d'amplification T2 qui devient conducteur lorsqu'il reçoit une impulsion négative, une diode dont la cathode est reliée à la grille de T2 et une tension L'2 de signe opposé à la tension L2.

La commande de L2 est, dans le cas de la fig. 2, constituée par une tension de référence positive Vm à laquelle est périodiquement superposée une impulsion qui donne à L2 une valeur négative maximale $V_I$.

Chaque impulsion de tension négative polarise la photodiode en direct. La tension négative $V_I$ est alors directement appliquée à la grille du transistor T2 dont la capacité de grille $C_G$ se charge à $V_I$. Dès le début de la diminution de l'impulsion, la tension $V_I$ de la grille polarise la photodiode dont la cathode est à la tension positive $V_m$, en inverse. La photodiode se trouve en position détection. Tout photon incident va la décharger. L'expression de la tension $V_G$ sur la grille de T2 après chaque impulsion de la tension négative L2 est obtenue en tenant compte de la capacité $C_D$ de la photodiode en inverse et en écrivant d'abord la variation de charge dQ qui se produit aux bornes des capacités $C_D$ et $C_G$ en série lors du passage de la tension de commande L2 de $V_I$ à $V_m$:

$$dQ = \frac{C_D \cdot C_G}{C_D + C_G} \cdot (V_m - V_I)$$

Cette variation de charge dQ provoque une différence de potentiel de polarisation $V_{PD}$ de la photodiode égale à:

$$V_{PD} = \frac{dQ}{C_D} = \frac{C_G}{C_D + C_G} \cdot (V_m - V_I)$$

La tension $V_G$ sur la grille de T2 s'écrit alors:

$$V_G = V_m - V_{PD} = V_m \cdot \frac{C_D}{C_D + C_G} + V_I \cdot \frac{C_G}{C_D + C_G}$$

On constate donc qu'il est possible, en jouant sur les valeurs de $V_m$ et $V_l$, de polariser la diode en inverse et de rendre conducteur le transistor d'amplification T2 qui lui est associé.

Les charges créées dans la photodiode par le rayonnement à détecter se retrouvent aux bornes des capacités de grille $C_G$ et de diode $C_D$ qui, par rapport à ces charges, sont en parallèle. Le choix des valeurs relatives de $C_D$ et de $C_G$ doit répondre aux deux impératifs suivants:

— les capacités $C_D$ et $C_G$ ne doivent pas être trop fortes pour que la tension obtenue aux bornes de la capacité ($C_D + C_G$) ne soit pas trop affaiblie;

— la capacité $C_G$ ne doit pas être trop faible devant $C_D$ si on veut éviter d'avoir à imposer une différence de polarisation de la photodiode $V_{PD}$ de l'ordre de 10 V qui est nécessaire pour obtenir un bon fonctionnement de la photodiode.

La photodiode est donc périodiquement mise en inverse par L2. Ce mode de mise en inverse de la photodiode présente le grand avantage de ne pas nécessiter de transistor relié à la cathode de la diode et destiné à la mettre en inverse.

Les fuites dues au transistor de mise en inverse à l'état bloqué dans la diode perturberaient en effet fortement le fonctionnement de la matrice.

Entre deux impulsions négatives sur L2 qui mettent la diode en direct, l'impulsion de déblocage L1 (qui rend conducteur T1) entraîne le passage d'un courant représentatif du rayonnement reçu par chaque photodiode dans les colonnes $CL_1$, $CL_2$, ... $CL_n$ vers les moyens de transfert 1 et l'amplificateur vidéo 2.

L'inconvénient du module élémentaire qui vient d'être décrit est que le courant de lecture $I_{DS}$ qui circule dans les transistors T2 d'une même ligne lors du déblocage des transistors T1 ne varie pas de façon simple en fonction de la tension $V_{GS}$ entre la grille et la source de chaque transistor T2, qui porte l'information sur le rayonnement reçu par chaque photodiode.

Selon que la tension drain de T2 est supérieure ou inférieure à sa tension grille, le courant $I_{DS}$ dans T2 s'écrit:

— $I_{DS} = K \cdot \dfrac{W}{L} (V_{GS} - V_{TH})^2$, c'est le fonctionnement en régime saturé;

— $I_{DS} = K \cdot \dfrac{W}{L} \left( (V_{GS} - V_{TH}) \cdot V_{DS} - \left( \dfrac{V_{DS}}{2} \right) 2^2 \right)$,

c'est le fonctionnement en régime triode,

où $K$, $W$, $L$, $V_{GS}$, $V_{TH}$ et $V_{DS}$ ont la signification habituelle en technologie MOS.

Le courant $I_{DS}$ ne varie pas de façon simple en fonction de la tension $V_{GS}$, même si on ne considère que les faibles variations de courant et de tensions, auquel cas on obtient:

$$d\, I_{DS} = \frac{\delta\, I_{DS}}{\delta V_{GS}} \cdot d\, V_{GS}$$

Pour éviter l'inconvénient dû au fait que le courant $I_{DS}$ ne varie pas de façon simple en fonction de la tension $V_{GS}$, une capacité de stockage $C_S$ est montée en parallèle sur chaque transistor d'amplitude T2.

Chaque transistor T2 est passant tant que ($V_{GS} - V_{TH}$) est positif. Le passage du courant à travers T2 réduit la tension $V_{GS}$ et augmente le potentiel $V_S$ en A en déchargeant la capacité de stockage $C_S$ jusqu'à ce que $V_{GS}$ égale $V_{TH}$ et que l'on ait donc: $V_S = V_G - V_{TH}$. Le potentiel $V_S$ au point A s'autostabilise donc à la valeur ($V_G - V_{TH}$). Il y a transfert du signal $V_G$ porté par la grille de T2, qui représente l'information reçue par chaque photodiode, aux bornes de la capacité de stockage $C_S$. Cette capacité de stockage $C_S$ a une valeur choisie environ cent fois supérieure à la somme de la capacité de la diode en inverse $C_D$ et de la capacité de grille $C_G$ du transistor T2. En transférant le signal $V_G$ aux bornes de $C_S$, on profite donc d'un gain en charge de l'ordre de cent également. L'impulsion de déblocage L1 qui rend conducteurs les transistors T1 provoque, dans les colonnes $CL_1$, $CL_2$, ... $CL_n$, le passage d'un courant qui est destiné à recharger chaque capacité $C_S$ à sa valeur initiale et qui est donc représentatif du signal $V_S = V_G - V_{TH}$ établi au point A.

Le module élémentaire comportant une capacité de stockage $C_S$ présente deux inconvénients:

— d'une part, le courant de lecture qui passe dans $CL_1$, $CL_2$, ... $CL_n$ dépend du signal $V_S = V_G - V_{TH}$ établi en chaque point A, borne d'un transistor T2. Or la tension de seuil $V_{TH}$ des transistors MOS T2 varie fortement d'un transistor T2 à l'autre;

— d'autre part, le courant qui traverse chaque transistor T2 tant que $V_S$ n'égale pas ($V_G - V_{TH}$), devient de plus en plus faible au fur et à mesure que $V_S$ tend vers ($V_G - V_{TH}$). Il faut alors une constante de temps de l'ordre de la seconde pour transférer au point A une fraction proche de 1 (par exemple 99%) de la tension ($V_G - V_{TH}$). Il n'est donc pas possible de fonctionner en temps réel.

Ces deux inconvénients sont supprimés si chaque module élémentaire comporte, en plus de la capacité de stockage $C_S$, une résistance $R_L$ montée entre le point A de T2 et un potentiel de référence L3 véhiculé par une ligne horizontale.

Les valeurs de la résistance $R_L$ et du potentiel de référence L3 sont choisies de façon que le point A de T2 soit porté à un potentiel égal à celui qu'il prend en l'absence de résistance $R_L$, lorsque la grille du transistor T2 ne reçoit aucun signal. Le signal qui traverse $CL_1$, $CL_2$, ... $CL_n$ lors de la lecture dépend donc directement du rayonnement reçu par chaque photodiode.

La tension continue de commande L2 qui met chaque photodiode e en inverse et qui rend T2 conducteur entraîne, à travers T2 et $C_S$, le passage d'un courant qui décharge $C_S$. L'impulsion L1 de déblocage de T1 provoque le passage dans $CL_1$, $CL_2$, ... $CL_n$ d'un courant de lecture qui dépend directement du rayonnement reçu par chaque photodiode e et qui recharge $C_S$.

L'adjonction de la résistance $R_L$ entraîne:

— d'une part, la suppression de l'influence de la tension de seuil $V_{TH}$ des transistors T2 sur le signal de lecture. En fait, en pratique, le même potentiel L3 est appliqué aux résistances $R_L$ des modules élémentaires d'une même ligne d'éléments photosensibles et la valeur des résistances

$R_L$ est ajustée, par usinage laser par exemple, de façon que le point A de chaque transistor T2 reçoive un potentiel égal à celui de ce point A en l'absence de résistance $R_L$ et de signal sur la grille de T2;

— d'autre part, une constante de temps de transfert de la variation de tension sur la grille de T2 au point A quasiment instantanée de l'ordre de $10^{-4}$ s.

Il faut que la résistance $R_L$ soit de l'ordre de deux à trois fois la valeur de l'impédance du transistor T2 pour la polarisation grille de repos qui lui est appliquée pour qu'une fraction proche de 1 de la variation de tension sur la grille T2 soit transmise au point A.

Un autre mode de réalisation du module élémentaire peut être envisagé dans lequel il n'y a pas de capacité de stockage $C_S$ en parallèle sur T2, mais dans lequel la résistance $R_L$ est conservée. Dans ce cas, il circule dans $CL_1$, $CL_2$, ... $CL_n$, lors du déblocage des transistors T1 par L1, un courant qui dépend directement de la modification de potentiel au point A et donc du signal reçu par la photodiode.

La tension de commande L2 peut être, comme L1, fournie par le registre 4 qui véhicule une impulsion de déblocage. La tension de référence L3 est généralement constituée par la borne positive de la source de tension E.

Chaque module élémentaire comporte donc trois lignes L1, L2, L3 qui véhiculent des impulsions ou des signaux de commande.

En résumé, le premier module élémentaire décrit peut être constitué uniquement par les transistors T1 et T2 et la photodiode e, mais il peut aussi comporter une capacité $C_S$ et une résistance $R_L$ ou l'un ou l'autre de ces éléments.

La matrice selon l'invention présente l'intérêt de permettre une lecture non destructive. La mise en conduction des transistors T1 d'une ligne ne modifie pas l'information inscrite sur les photodiodes.

Il est possible, selon les cas, d'augmenter les temps d'intégration des photodiodes, c'est-à-dire l'intervalle de temps entre les impulsions de remise à zéro des photodiodes tout en continuant à prélever le signal aux points A par déblocage des transistors T1 à la fréquence image télévision normale. Cela permet d'obtenir une bonne image, sans trop de bruit. Il est également possible de diminuer le temps d'intégration pour obtenir une image non bougée.

La fig. 3 représente un deuxième mode de réalisation de la matrice selon l'invention, dans lequel les éléments photosensibles sont constitués par des photodiodes e.

Dans ce cas, les moyens d'adressage et d'amplification sont confondus et sont constitués par les transistors T1. La grille de ces transistors reçoit périodiquement une impulsion de déblocage L1 par l'intermédiaire d'une photodiode e connectée de telle façon que cette impulsion la rende passante. Dans l'exemple représenté sur la fig. 3, le transistor T1 est rendu passant par une impulsion positive et la cathode de la photodiode e est reliée à la grille de T1. Chaque impulsion positive L1 provoque donc la mise en direct de la photodiode e et le déblocage du transistor T1. Ensuite, L1 prend une valeur négative qui met la photodiode e en inverse et qui bloque T1. Le rayonnement reçu par la photodiode en inverse modifie le potentiel de grille du transistor T1 et le moment de mise en conduction de T1, cette modification fournit donc une représentation amplifiée du rayonnement reçu par chaque photodiode.

Il serait bien sûr possible d'avoir le même fonctionnement en utilisant un transistor T1 rendu passant par une impulsion négative, une photodiode dont l'anode est reliée à la grille de T1 et une impulsion de déblocage L'1 de signe contraire.

On peut mettre en parallèle, sur chaque photodiode e, une résistance $R_L$ dont la valeur est ajustée, d'un module à l'autre, de façon que le courant de fuite dans cette résistance, en l'absence de rayonnement sur la photodiode, amène le potentiel de grille du transistor T1 à une même valeur pour tous les modules élémentaires. Il est ainsi possible d'annuler l'effet dû à la dispersion des tensions de seuil des transistors T1.

Le module représenté sur la fig. 3 permet, comme celui représenté sur la fig. 1, de réaliser une lecture non destructive de l'information stockée dans la photodiode.

Il est possible de diminuer le nombre de lignes horizontales transportant les tensions ou impulsions de commande nécessaires au fonctionnement de chaque module élémentaire, ce qui est très avantageux pour la réalisation pratique de la matrice.

Ainsi, dans le cas du module représenté sur la fig. 2, il suffit de choisir des transistors d'adressage T1 et d'amplification T2 qui sont rendus conducteurs par des impulsions de signes différents pour qu'il ne soit plus nécessaire d'avoir deux lignes L1 et L2 et qu'une seule ligne L'1 puisse véhiculer les tensions de commande des transistors T1 et T2. Ces tensions de commande, ayant des signes différents, ne déclenchent qu'un seul des transistors T1 ou T2 à la fois.

Le potentiel de référence L3 de la fig. 2 est généralement constitué par la borne positive de la source de tension E. Il est possible d'éviter la réalisation matérielle de la ligne L3 qui connecte les résistances $R_L$ à la borne positive de E. Il suffit pour cela d'utiliser comme potentiel de référence la tension véhiculée par l'une des lignes L1, L2 ou L'1 de la ligne de modules élémentaires suivante, cela dans le cas de la fig. 2.

Il est donc possible dans le cas des matrices représentées sur la fig. 2 de n'utiliser qu'une seule ligne horizontale véhiculant les tensions ou signaux de commande à tous les modules élémentaires d'une même ligne d'éléments photosensibles.

La matrice de détection selon l'invention est utilisée dans les intensificateurs d'images radiologiques où elle assure soit la conversion des photons X incidents en signal électrique de lecture, soit seulement la détection d'un rayonnement visible dans le cas où les photons X incidents sont convertis en photons de moindre énergie par un scintillateur. Ce scintillateur est alors constitué par un panneau mis en contact avec la mosaïque détectrice.

## Revendications

1. Matrice de détection d'un rayonnement électromagnétique, comportant un élément photosensible à chaque point d'intersection de lignes et de colonnes, les éléments photosensibles (e) étant réalisés en technologie film mince sur un même substrat diélectrique, et des moyens d'adressage des éléments photosensibles, constitués par un transistor MOS (T1) réalisé en technologie film mince, qui est associé à chaque élément photosensible, caractérisée en ce que:
— chaque transistor d'adressage (T1) reçoit périodiquement sur une grille une impulsion de déblocage (L1) appliquée simultanément à tous les transistors d'adressage (T1) d'une même ligne d'éléments photosensibles;
— des moyens d'amplification (3) du signal électrique fourni par chaque élément photosensible sont associés à chaque élément photosensible et réalisés en technologie film mince;
— des moyens transfèrent vers un amplificateur vidéo (2) les signaux électriques fournis par chaque ligne d'éléments adressée, ces moyens étant constitués par un dispositif à entrées parallèles et à sortie série auquel sont reliés tous les transistors d'adressage (T$_1$).

2. Matrice selon la revendication 1, caractérisée en ce que les éléments photosensibles sont des photodiodes.

3. Matrice selon la revendication 2, caractérisée en ce que des moyens d'amplification sont constitués par un transistor MOS en technologie film mince (T2), reliée entre chaque transistor d'adressage (T1) et la borne positive de la source de tension d'alimentation (E) de la matrice, la grille de chaque transistor d'amplification étant reliée à une photodiode (e) qui reçoit une tension de commande (L2), appliquée aux photodiodes d'une même ligne, et constituée par une tension de référence à laquelle est périodiquement superposée une impulsion qui donne au signal un signe opposé à celui de la tension de référence et qui provoque, lors de sa venue, la mise en direct des photodiodes et, lors de sa disparition, la mise en inverse des photodiodes ainsi que la conduction des transistors d'amplification (T2) associés.

4. Matrice selon la revendication 3, caractérisée en ce que les transistors d'adressage (T1) et l'amplification (T2) sont rendus conducteurs par des impulsions de signes différents et en ce que ces impulsions sont véhiculées sur une même ligne L' pour chaque ligne de modules élémentaires.

5. Matrice selon l'une des revendications 3 ou 4, caractérisée en ce qu'une capacité de stockage (CS) est montée en parallèle sur chaque transistor d'amplification (T2).

6. Matrice selon la revendication 5, caractérisée en ce que la valeur de la capacité de stockage (C$_S$) est environ cent fois supérieure à la somme de la capacité de la photodiode en inverse et de la capacité de la grille du transistor d'amplification (T2) associé.

7. Matrice selon l'une des revendications 3 à 6, caractérisée en ce qu'une résistance (R$_L$) est reliée entre le point commun (A) à chaque transistor d'adressage (T1) et d'amplification (T2) et un potentiel de référence (L3), les valeurs de la résistance et du potentiel de référence étant telles que le point commun soit porté à un potentiel égal à celui qu'il prend en l'absence de résistance (R$_L$) et sans signal sur la grille du transistor d'amplification (T2).

8. Matrice selon la revendication 7, caractérisée en ce que le potentiel de référence (L3) appliqué à chaque résistance (R$_L$) d'une même ligne d'éléments photosensibles est véhiculé par l'une des lignes véhiculant les tensions ou impulsions de commande (L1, L2, L') de la ligne de modules élémentaires suivante.

9. Matrice selon la revendication 2, caractérisée en ce que les moyens d'amplification sont constitués par chaque transistor d'adressage (T1) dont la grille reçoit périodiquement l'impulsion de blocage (L1) par l'intermédiaire d'une photodiode (e) connectée de telle façon que cette impulsion la rende passante, la photodiode recevant ensuite une tension qui la met en inverse et bloque le transistor d'adressage, le moment de mise en conduction de ce transistor dépendant ensuite du flux incident reçu par la photodiode.

10. Matrice selon la revendication 9, caractérisée en ce qu'une résistance (R$_L$) est montée en parallèle sur chaque photodiode (e), la valeur de cette résistance étant telle que le potentiel de la grille de tous les transistors d'adressage (T1), en l'absence de rayonnement sur la photodiode, soit le même.

11. Matrice selon l'une des revendications précédentes, caractérisée en ce que les moyens de transfert sont constitués par un registre à décalages ou un multiplexeur.

12. Intensificateur d'images radiologiques, caractérisé en ce qu'il comporte une matrice de détection de rayonnement selon l'une des revendications précédentes.

## Claims

1. A matrix for detecting an electromagnetic radiation, comprising a light-sensitive element at each cross point of lines and columns, the light-sensitive elements (e) being realised on a common dielectric substrate according to the thin-film technology, and comprising means for addressing the light-sensitive elements constituted by a MOS-transistor (T1) realized according to the thin-film technology and associated to each of the light-sensitive elements,
characterized in that
— each address transistor (T1) receives periodically by its grid an unlocking pulse (L1) which is applied simultaneously to all address transistors (T1) of one line of light-sensitive elements,

— means (3) for amplifying the electric signal furnished by each light-sensitive element are associated to each light-sensitive element and are realised according to the thin-film technology,

— means transfer the electric signals furnished by each line of addressed elements to a video amplifier (2), these means being constituted by a device having parallel inputs and a series output and being connected to all the address transistors (T1).

2. A matrix according to claim 1, characterized in that the light-sensitive elements are constituted by photodiodes.

3. A matrix according to claim 2, characterized in that amplifications means are constituted by a MOS-transistor (T2) realized according to the thin-film technology and connected between each address transistor (T1) and the positive clamp of the feed voltage source (E) of the matrix, the grid of each amplification transistor being connected to a photodiode (e) which receives a control voltage (L2) applied to the photodiodes of one line and constituted by a reference voltage to which a pulse is periodically superposed, said pulse changing the sign of the signal with respect to the reference voltage and causing, when it appears, a forward polarisation of the photodiodes and, when it disappears, a backward polarisation of the photodiodes and causing the associated amplification transistors (T2) to become conductive.

4. A matrix according to claim 3, characterized in that the address (T1) and amplification transistors (T2) are rendered conductive by pulses of different signs and that the pulses are transferred on a common line (L') for each line of elementary modules.

5. A matrix according to one of claims 3 or 4, characterized in that a storage capacity (CS) is mounted in parallel to each amplification transistor (T2).

6. A matrix according to claim 5, characterized in that the value of the storage capacity ($C_S$) is about a hundred times greater than the sum of the potodiode capacity when backwardly polarised and the grid capacity of the associated amplification transistor (T2).

7. A matrix according to one of claims 3 to 6, characterized in that a resistor ($R_L$) is connected between the common point (A) of each address transistor (T1) and of each amplification transistor (T2) and a reference potential (L3), the values of said resistor and of said reference potential being such that the common point is brought to a potential which is equal to the potential of said point if the resistor ($R_L$) and the signal at the grid of the amplification transistor (T2) were absent.

8. A matrix according to claim 7, characterized in that the reference potential (L3) which is applied to each resistor ($R_L$) of one line of light-sensitive elements is transferred by one of the lines bearing the voltages or control pulses (L1, L2, L') of the next following line of elementary modules.

9. A matrix according to claim 2, characterized in that the amplification means are constituted by each address transistor (T1), the grid of which receives periodically the locking pulse (L1) via a photodiode (e) connected in a way to render this diode conductive, the photodiode then receiving a voltage which polarizes it backwardly and which locks the address transistor, the instant in which this transistor becomes conductive depending then on the incident flux received by the photodiode.

10. A matrix according to claim 9, characterized in that a resistor ($R_L$) is mounted in parallel to each photodiode (e), the value of said resistor being such that the grid potential of all the address transistors (T1) is the same in the absence of irradiation of the photodiode.

11. A matrix according to one of the preceding claims, characterized in that the transfer means are constituted by a shift register or a multiplexer.

12. Intensifier of radiological images, characterized in that it comprises a matrix for detecting a radiation according to one of the preceding claims.

**Patentansprüche**

1. Matrix zur Detektion einer elektromagnetischen Strahlung, mit einem lichtempfindlichen Element an jedem Kreuzungspunkt zwischen Zeilen und Spalten, wobei die lichtempfindlichen Elemente (e) nach der Dünnschichttechnologie auf einem gemeinsamen dielektrischen Substrat hergestellt sind, und mit Miteln zur Adressierung der lichtempfindlichen Elemente, bestehend aus einem MOS-Transistor (T1), der nach der Dünnschichttechnologie hergestellt ist und jedem lichtempfindlichen Element zugeordnet ist, dadurch gekennzeichnet, dass

— jeder Adressiertransistor (T1) periodisch an einem Steueranschluss einen Freigabeimpulse (L1) zugeführt erhält, wobei dieser Impuls gleichzeitig an alle Adressiertransistoren (T1) einer Zeile von lichtempfindlichen Elementen angelegt wird,

— Mitteln (3) zur Verstärkung des von jedem lichtempfindlichen Element gelieferten elektrischen Signals jedem lichtempfindlichen Element zugeordnet und in Dünnfilmtechnologie hergestellt sind, und

— Mittel die von jeder adressierten Zeile von Elementen gelieferten elektrischen Signale an einen Bildverstärker (2) übertragen und von einer Vorrichtung mit parallelen Eingängen und Reihenausgang gebildet werden, an die alle Adressiertransistoren (T1) angeschlossen sind.

2. Matrix nach Anspruch 1, dadurch gekennzeichnet, dass die lichtempfindlichen Element Photodioden sind.

3. Matrix nach Anspruch 2, dadurch gekennzeichnet, dass Verstärkungsmittel aus einem in Dünnschichttechnologie hergestellten MOS-Transistor (T2) bestehen, der zwischen jedem Adressiertransistor (T1) und der positiven Klemme der Stromversorgungsquelle (E) der Matrix angeschlossen ist, wobei der Steueranschluss jedes Verstärkungstransistors an eine Photodiode (e) angeschlossen ist, der eine Steuerspannung (L2) zugeführt wird, wobei Steuerspannung an die Photodioden einer gemeinsamen Zeile angelegt wird und aus einer Bezugsspannung besteht, der periodisch ein Impuls überlagert wird, wobei dieser Impuls dem Signal ein zur Bezugsspannung umgekehrtes Vorzeichen verleiht und bei seinem Auftreten die Photodioden direkt vorspannt, während bei seinem Verschwinden die Photodioden invers vorgespannt und die zugeordneten Verstärkungstransistoren (T2) leitend gemacht werden.

4. Matrix nach Anspruch 3, dadurch gekennzeichnet, dass die Adressier- (T1) und Verstärkungstransistoren (T2) durch Impulse unterschiedlicher Polarität leitend gesteuert werden, und dass diese Impulse auf einer gemeinsamen Leitung für jede Zeile elementarer Moduln übertragen werden.

5. Matrix nach einem der Ansprüche 3 oder 4, dadurch gekennzeichnet, dass eine Speicherkapazität (CS) parallel zu jedem Verstärkungstransistor (T2) angeordnet ist.

6. Matrix nach Anspruch 5, dadurch gekennzeichnet, dass der Wert der Speicherkapazität (CS) etwa 100mal grösser als die Summe der Photodiodenkapazität bei inverser Vorspannung und der Steueranschlusskapazität des Verstärkungstransistors (T2) ist.

7. Matrix nach einem der Ansprüche 3 bis 6, dadurch gekennzeichnet, dass ein Widerstand (R$_L$) zwischen dem gemeinsamen Punkt (A) jedes Adressier- (T1) und Verstärkungstransistors (T2) und einem Bezugspotential (L3) eingefügt ist, wobei die Werte des Widerstands und des Bezugspotentials so gewählt sind, dass der gemeinsame Punkt auf ein Potential gebracht wird, das dem gleicht, das sich dort in Abwesenheit des Widerstands (R$_L$) und ohne Signal am Steueranschluss des Verstärkungstransistors (T2) einstellt.

8. Matrix nach Anspruch 7, dadurch gekennzeichnet, dass das Bezugspotential (L3), das an jeden Widerstand (R$_L$) einer gemeinsamen Zeile von lichtempfindlichen Elementen angelegt wird, auf einer der Leitungen übertragen wird, über die auch die Spannungen oder Steuerimpulse (L1, L2, L') der nächstfolgenden Zeile von Elementarmoduln übertragen wird.

9. Matrix nach Anspruch 2, dadurch gekennzeichnet, dass die Verstärkungsmittel von jedem Adressiertransistor (T1) gebildet werden, dessen Steueranschluss periodisch den Sperrimpuls (L1) über eine derart angeschlossene Photodiode (e) zugeführt erhält, dass dieser Impuls sie leitend macht, worauf die Photodiode eine Spannung zugeführt erhält, die sie invers vorspannt und den Adressiertransistor sperrt, wobei der Moment, an dem dieser Transistor dann leitend wird, vom Lichtfluss abhängt, der auf die Photodiode trifft.

10. Matrix nach Anspruch 9, dadurch gekennzeichnet, dass ein Widerstand (R$_L$) parallel zu jeder Photodiode (e) angeschlossen ist, dessen Wert so gewählt ist, dass das Potential am Steueranschluss aller Adressiertransistoren (T1) dasselbe ist, wenn keine Strahlung auf die Photodiode trifft.

11. Matrix nach einem der vorhergehenden Ansprüche, dadurch gekennzeichnet, dass die Übertragungsmittel aus einem Schieberegister oder einem Multiplexer gebildet werden.

12. Verstärker für radiologische Bilder, dadurch gekennzeichnet, dass er eine Matrix zur Detektion einer Strahlung nach einem der vorhergehenden Ansprüche aufweist.

Fig. 1

Fig. 2

Fig. 3